# EUROPEAN PATENT APPLICATION

(11) **EP 2 492 367 A1**
(43) Date of publication of application: **29.08.2012**
(21) Application number: 11182846.3
(22) Date of filing: 27.09.2011
(51) Int. Cl.: C23C 14/10, C23C 14/20, C23C 14/24, C23C 14/50

(54) **Surface coating method and device for exterior part**

(30) Priority: 23.02.2011 KR 20110016098
(71) Applicant: Samsung Electronics Co., Ltd., Suwon-si Gyeonggi-do 442-742 (KR)
(72) Inventor: Ohira, Shigeo, Suwon-si Gyeonggi-do 442-742 (KR); Lim, Yong-Pil, Suwon-si Gyeonggi-do 442-742 (KR); Park, Jong-Bae, Suwon-si Gyeonggi-do 442-742 (KR); Choo, Sung-Hwan, Suwon-si Gyeonggi-do 442-742 (KR); Kim, Jong-Hwa, Suwon-si Gyeonggi-do 442-742 (KR); Kim, Hak-Ju, Suwon-si Gyeonggi-do 442-742 (KR); Kim, Se-Jin, Suwon-si Gyeonggi-do 442-742 (KR)
(74) Representative: Jenkins, Richard Gavin

(57) **Abstract**

A surface coating method for an exterior part includes positioning one or more exterior part preforms, which are objects (29) to be surface-coated, within a deposition chamber (20) capable of revolution and rotation; positioning one or more tablets containing a coating component on an evaporation device (25) installed within an area surrounded by the revolution trace of the exterior part preforms; and depositing a coating layer to a surface of each of the exterior part preforms by evaporating the tablets while revolving and rotating the exterior part preforms. The surface coating method and device conduct the rotation and revolution of objects to be coated in while proceeding with a coating step, whereby an evaporated coating component can be uniformly diffused over the entire deposition chamber, and a uniform coating layer can be formed on the entire surface of each of the objects to be coated.

## Description

### 1. Field of the Invention

The present invention relates generally to an exterior part for a portable terminal, a home appliance or the like, and more particularly, to a surface coating method and device for an exterior part including a molded product of a metallic material, a plastic material, or a glass material forming an exterior part of a portable terminal, a home appliance, or the like which is frequently touched or operated by a user.

### 2. Description of the Related Art

In general, plastic injection-molded products are widely used as exterior parts of products intimately associated with daily life, such as household items, home appliances, and portable terminals, since they can be readily molded. Exterior parts including such injection-molded products are painted or coated depending on the use of the associated products. In particular, as the use of a portable terminal, such as a portable media reproducer, a digital diary, a tablet personal computer, and a mobile communication terminal, has been popularized, efforts have been made to improve and gentrify the external appearances of such products.

For example, a metallic texture may be provided on an external part of an injection-molded product by providing a gloss using paint for painting the exterior part. In particular, as the use of a mobile communication terminal has been popularized and various functions are integrated into such a mobile communication terminal due to the development of communication technologies, portable terminals are sometimes used as accessories for expressing the personalities of the users of the terminals. In addition, since there is limit in improving and gentrifying gloss or texture, portable terminal products provided with a tempered glass on the exterior parts thereof have appeared, and display devices thereof are frequently protected by window glass.

As metallic textures and high glossy coating have been popularized, fingerprint stains or foreign matter are brought into view more readily if an exterior part of a portable terminal or the like is polluted by the fingerprint stains or foreign matter. In addition, as the use of a smart phone, a vehicle navigation device, and a tablet PC, each of which is provided with a touch screen, has been popularized, the window glass of a display device provided with a touch screen function may cause reduce a user's enjoyment due to the user's fingerprint stains, pollution, and scratches caused by repeated use.

In addition, as kitchen appliances, such as refrigerators, provided with a display device and a network function have appeared, the spectrum of use of touch screens has extended. As a result, efforts are made to avoid stains, pollution and damage of the window glasses of display devices.

In order to prevent such pollution and damage of exterior parts, either anti-fingerprint coatings or super water-repellant coatings can be implemented. The anti-fingerprint coating or the super water-repellant coating allows adhered foreign matter to be readily removed while suppressing the adhesion of the foreign matter. The coating of such exterior parts is typically implemented by evaporating coating liquid using electronic beams within a deposition chamber so that the liquid can be deposited to the surface of such an exterior part.

However, such a conventional anti-fingerprint coating method or super water-repellant coating method has a limitation in that it is difficult to coat the entire surface of a product three-dimensional in shape. In other words, since anti-fingerprint coating or super water-repellant coating is implemented using such a conventional coating method, it is difficult to form a coating layer with a uniform thickness on a lateral side or the like.

In addition, there is a limitation in that even if the surfaces of a plurality of exterior part preforms are coated through a single coating process, coating cannot be implemented uniformly among the preforms. In other words, since evaporated coating material cannot be uniformly diffused within a deposition chamber, difference in terms of coating quality results among the final products.

### SUMMARY OF THE INVENTION

Accordingly, the present invention has been made to solve the above-mentioned problems occurring in the prior art. An aspect of the present invention provides a surface coating method and device for an exterior part, which enable anti-fingerprint or super water-repellant coating on external parts, such as various injection-molded products three-dimensional in shape, or glass.

Also, another aspect of the present invention provides a surface coating method and device for an exterior part which provides uniform coating quality of the surfaces of exterior parts which are simultaneously coated within the same deposition chamber.

In accordance with an aspect of the present invention, there is provided a surface coating method for an exterior part including positioning one or more exterior part preforms to be surface-coated within a deposition chamber which are capable of revolution and rotation; positioning one or more tablets containing a coating component on an evaporation device installed within an area surrounded by the revolution trace of the exterior part preforms; and depositing a coating layer to a surface of each of the exterior part preforms by evaporating the tablets while revolving and rotating the exterior part preforms.

The surface coating method for an exterior part, as described above, can be implemented by a surface coating device for an exterior part, including a mounting jig, on which one or more objects to be coated are arranged, and which is installed to be capable of revolution and rotation; and an evaporation device installed within an area surrounded by the revolution trace of the mounting jig, wherein one or more tablets, each of which contains a coating component, are arranged on the evaporation device.

The inventive surface coating method and device, as described above, provides for the rotation and revolution of objects to be coated while proceeding with a coating step, whereby an evaporated coating component can be uniformly diffused over the entire deposition chamber, and a uniform coating layer can be formed on the entire surface of each of the objects to be coated. In addition, there is an advantage in that it is possible to provide uniform quality of coating layers formed on the respective objects conducted in the same process since the rotation and revolution of a plurality of objects to be coated are repeated within a single deposition chamber. Moreover, a silicon particle layer is formed within a deposition chamber prior to conducting anti-fingerprint coating and super water-repellant coating, so that coating can be implemented smoothly and the coating process can be easily carried out.

### BRIEF DESCRIPTION OF THE DRAWINGS

The above and other aspects, features and advantages of the present invention will be more apparent from the following detailed description taken in conjunction with the accompanying drawings, in which:
FIG. 1 is a schematic view describing a method for surface-coating an exterior part in accordance with an embodiment of the present invention;
FIG. 2 illustrates a surface coating device for surface-coating an exterior part for conducting the method shown in FIG. 1; and
FIG. 3 is a perspective view illustrating a mounting jig of the surface coating device shown in FIG. 2.

### DETAILED DESCRIPTION OF EMBODIMENTS OF THE PRESENT INVENTION

Hereinafter, embodiments of the present invention will be described with reference to the accompanying drawings. In the following description, the same elements will be designated by the same reference numerals although they are shown in different drawings. Further, in the following description of the present invention, a detailed description of known functions and configurations incorporated herein will be omitted when it may unnecessarily obscure the subject matter of the present invention.

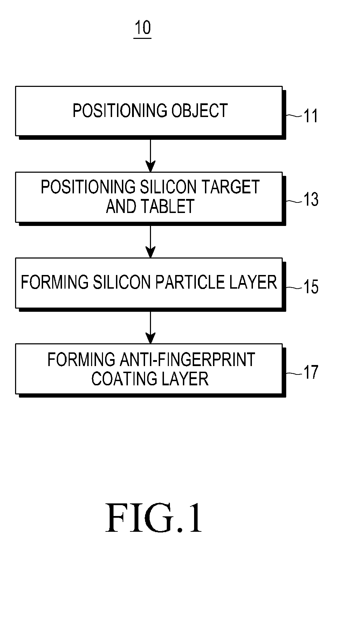

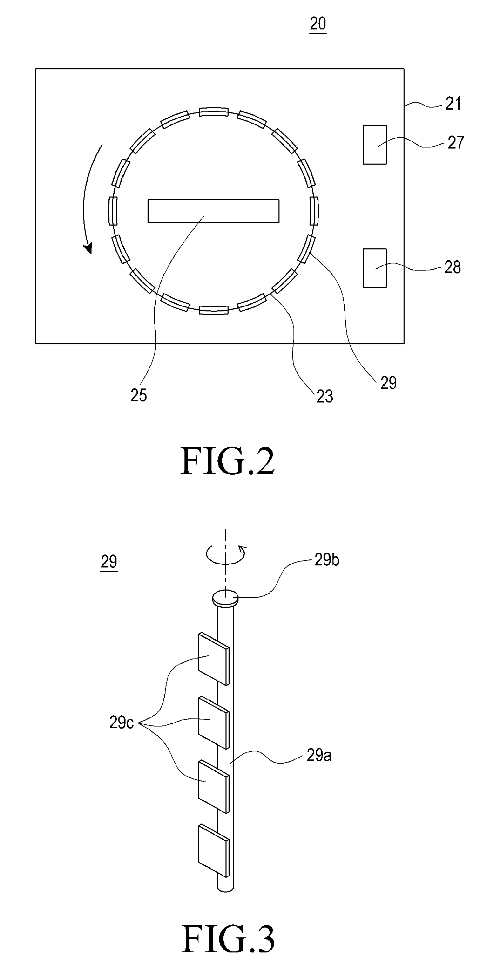

As shown in FIG. 1, a surface coating method 10 for surface-coating an exterior part in accordance with an embodiment of the present invention includes positioning one or more objects 29c to be coated (see FIG. 3) within a deposition chamber 21 at step 11 (hereinafter, this step will be referred to as "first positioning step"); positioning a silicon target and one or more tablets within the deposition chamber 21 at step 13 (hereinafter, this step will be referred to as "second positioning step"); sputtering the silicon target to form a silicon particle layer on a surface of each of the objects 29c at step 15 (hereinafter, this step will be referred to as "layer forming step"), and forming a coating layer on the surface of each of the objects 29c at step 17 (hereinafter, this step will be referred to as "coating step").

The coating layer formed in the coating step 17 is formed from an anti-fingerprint component and/or a super water-repellant component, and the silicon particle layer is applied so as to enhance the deposition force of the components of the coating layer in relation to the objects 29c. Therefore, if the components of the coating layer can be sufficiently deposited to the objects 29c, it is not necessarily required to form the silicon particle layer in conducting the inventive surface coating method 10. In other words, the first positioning step and the layer forming step are preferably selected depending on the deposition force of the coating components in relation to the objects 29c.

An apparatus for coating an object according to the above mention surface coating method 10 can be utilized, for example, on an injection-molded product, acrylic products and glass, which will form an exterior part of a portable terminal, a home appliance or the like. FIG. 2 schematically shows a surface coating device 20 fabricated capable of conducting the inventive surface coating method 10, and FIG. 3 is a perspective view showing a mounting jig 29 of the surface coating device 20 shown in FIG. 3.

As shown in FIGs. 2 and 3, the surface coating device 20 includes a mounting jig 29 installed within a deposition chamber 21, and an evaporation device 25, and if desired, the surface coating device 20 may further include a sputtering device 27 for forming a silicon particle layer, and a gas introduction device 28. At this time, one or more objects 29c to be coated are arranged on the mounting jig 29, wherein the objects 29c are components of an exterior part of a portable terminal or the like, which may form a housing, or a window glass of a display device.

The mounting jig 29 extends in one direction and rotates about a rotation axis arranged in the longitudinal axial direction thereof, and revolves along a predetermined path, or trace. It is possible to install only one mounting jig 29 within the deposition chamber 21. However, it is also possible to install two or more mounting jigs 29 arranged in the revolution direction with a uniform interval. The objects 29c are preferably arranged on one side of the mounting jig 29 along the longitudinal direction on the mounting jig 29.

Although the present embodiment exemplifies that the objects 29c are arranged on only one side of the mounting jig 29 in one row, it is possible to arrange the objects around the mounting jig 29 in two rows, wherein the number of rows may be properly determined according to the size of the mounting jig 29.

Meanwhile, a rotation protrusion 29b is provided on at least one end of the body 29a of the mounting jig 29 to provide a means for installing the mounting jig 29 within the deposition chamber 21. The rotation protrusion 29b is rotatably coupled to a frame which revolves within the mounting chamber 21. As a result, if the frame 23 revolves, the mounting jig 29 can revolve within the deposition chamber 21, and rotate on the frame 23.

The evaporation device 25 is provided so as to evaporate one or more tablets, each of which contains a coating material, wherein the evaporation device 25 is installed within an area surrounded by the revolution trace of the mounting jig 29. The coating material may contain an anti-fingerprint component and/or a water-repellant component. The evaporation device 25 may include a plurality of heaters (not shown), for example tungsten filaments, wherein each of the heaters is provided with a tablet.

If power is provided to the heaters under a preset condition, the tablets are heated and evaporated, thereby providing evaporated coating components within the deposition chamber. The heaters, and hence the tablets are preferably arranged with an equal interval in the revolution direction of the mounting jig 29 and the objects 29c. In addition, although not shown in the drawings, a plurality of tablets may be arranged along the longitudinal direction of the mounting jig 29 with an equal interval. The interval and the number of the tablets may be set in consideration of the size of the deposition chamber 21 and the number of the objects 29c.

By arranging the tablets with an equal interval within the deposition chamber 21, it is possible to uniformly distribute the evaporated coating components within the entirety of the deposition chamber 21. In addition, by arranging the objects 29c on the mounting jig 29 which rotates and revolves within the deposition chamber 21, it is possible to obtain uniform coating of the objects 29c coated under the same condition. Moreover, since the objects 29c are arranged on the rotating and revolving mounting jig 29c within the deposition chamber 21 where evaporated coating components are evenly distributed, the entire surfaces of the objects 29c can be formed with an evenly coated layer even if each of the objects 29 has a three-dimensional shape rather than a flat shape.

Meanwhile, the objects 29c rotate together with the mounting jig 29 and rotate about the rotation axis of the mounting jig 29 as the mounting jig 29 rotates. However, it shall be noted that the revolution of the objects 29c according to the rotation of the mounting jig 29 may be described as the rotation of the objects 29c together with the mounting jig 29 when describing a specific embodiment of the present invention.

The sputtering device 27 is a device for sputtering a silicon target so as to form a silicon particle layer on a surface of an object to be coated, so that coating components can be smoothly deposited on the surface. The silicon target may be formed from any one component selected from pure silicon (Si), silicon oxide (SiO), and silicon dioxide (SiO₂). The gas introduction device 28 supplies reaction gas into the deposition chamber 21, wherein the reaction gas is preferably oxygen. If the silicon target is formed from silicon dioxide, it is not necessarily required to introduce the reaction gas into the deposition chamber 21. The silicon component scattered within the deposition chamber 21 by the sputtering device 27 reacts with the reaction gas supplied by the gas introduction device 28, thereby producing silicon oxide or silicon dioxide particles, which are deposited on the surfaces of the objects 29c, thereby forming a silicon particle layer. As the silicon particle layer is formed on the surface of each of the objects 29c, an anti-fingerprint component and/or a water-repellant component are smoothly deposited to the surface.

The surface coating method ,with reference to FIGs. 1 to 3, includes the first positioning step 11 and is the step of arranging the objects 29c on the mounting jig 29, wherein the objects 29c are arranged on the mounting jig 29 in a single row or two or more rows.

The second position step 13 is the step of arranging a silicon target and one or more tablets, each of which contains a coating component, within the deposition chamber 21, wherein the silicon target is arranged on the sputtering device 27, and the tablets are arranged on the heaters of the evaporation device 25, respectively. Although FIG. 2 illustrates only one sputtering device 27, it is also possible to provide two or more sputtering devices to simultaneously sputter two or more silicon targets, while also providing two or more tablets. The silicon target may be formed from pure silicon, silicon oxide, or silicon dioxide as described above.

In the layer forming step 15, reaction gas is supplied to the interior of the deposition chamber using the gas introduction device 28 simultaneously with sputtering the silicon target arranged within the deposition chamber 21. During the sputtering process, silicon particles are scattered within the deposition chamber 21 and react with the reaction gas, thereby producing silicon oxide or silicon dioxide particles. The produced silicon oxide or silicon dioxide particles are deposited to the surfaces of the objects 29c, thereby forming a silicon particle layer.

In the process of forming the silicon particle layer, it is desirable to rotate and revolve the mounting jig 29. In general, although the silicon dioxide particles produced within the deposition chamber 21 are uniformly distributed in the entirety of the interior of the deposition chamber 21, it is possible to diffuse the silicon dioxide particles in the entirety of the interior of the deposition chamber 21, and to form uniform silicon particle layers on the objects 29c. Meanwhile, as described above, if the coating components of the tablets can be sufficiently deposited to the objects 29c, it is possible to omit the steps of positioning the silicon target within the deposition chamber 21 and forming the silicon particle layer. In addition, even if a sputtering process for forming the silicon particle layer is conducted, it is not necessarily required to introduce reaction gas if the silicon target is formed from silicon dioxide.

The coating step 17 is the step of heating and evaporating the tablets to deposit one or more coating components to the objects 29c. The evaporated coating components are deposited on the objects 29c, thereby forming a coating layer. As described above, it is possible to arrange a plurality of tablets within the deposition chamber 21, wherein the tablets are preferably arranged on the mounting jig 29 along the direction of arranging the objects 29c and along the revolution direction of the mounting jig 29 with an equal interval.

The coating layer formed through the above processes contains an anti-fingerprint or super water-repellant component, whereby it is possible to prevent a surface of a portable terminal or the like from being polluted by foreign matter or fingerprint stains, and such foreign matter or fingerprint stains can be readily removed even if the surface is polluted by the foreign matter or fingerprint stains.

The inventive coating method 10 and apparatus 20 may be used not only for coating a case, glass, or acrylic window of a display device with a touch screen function of a portable terminal, but also for coating a surface of an exterior case of a home appliance, such as a refrigerator or an air conditioner, or a case or a display window of an information device, such as a notebook computer or a vehicle navigation device, whereby the quality of exterior parts can be improved.

While the invention has been shown and described with reference to certain embodiments thereof, it will be understood by those skilled in the art that various changes in form and details may be made therein without departing from the spirit and scope of the invention as defined by the appended claims.

## Claims

1. A surface coating method for an exterior part comprising:
positioning one or more exterior part preforms to be surface-coated, within a deposition chamber, which are capable of revolution and rotation;
positioning one or more tablets containing a coating component on an evaporation device installed within an area surrounded by a revolution trace of the exterior part preforms; and
depositing a coating layer to a surface of each of the exterior part preforms by evaporating the tablets while revolving and rotating the exterior part preforms.

2. The method as claimed in claim 1, wherein the coating component comprises an anti-fingerprint component and/or a super water-repellant component.

3. The method as claimed in claim 1 or 2, further comprising:
arranging a silicon target on a sputtering device installed within the deposition chamber; and
introducing reaction gas into the deposition chamber while conducting sputtering using the silicon target, prior to depositing the coating layer,
wherein a silicon particle layer is formed on the surface of each of the exterior part preforms.

4. The method as claimed in one of the preceding claims, wherein the tablets are heated and evaporated by heaters mounted on the evaporation device.

5. The method as claimed in one of the preceding claims, wherein when positioning the tablets, the tablets are arranged along the direction of arranging the exterior part preforms with a uniform interval.

6. The method as claimed in one of the preceding claims, wherein when positioning the tablets, the tablets are arranged along the revolution direction of the exterior part preforms with a uniform interval.

7. A surface coating device for an exterior part, comprising:
a mounting jig, on which one or more objects to be coated are arranged, and which is installed to be capable of revolution and rotation; and
an evaporation device installed within an area surrounded by a revolution trace of the mounting jig,
wherein one or more tablets, each of which contains a coating component, are arranged on the evaporation device.

8. The surface coating device as claimed in claim 7, wherein the mounting jig extends in one direction, and rotates about a rotation axis arranged along the extending direction of the mounting jig.

9. The surface coating device as claimed in claim 8, wherein the objects are mounted along the extending direction of the mounting jig, and the tablets are arranged in the direction of arranging the objects with a uniform interval.

10. The surface coating device as claimed in one of the claims 7 to 9, wherein a plurality of mounting jigs are arranged along the revolution direction of the mounting jigs with a uniform interval.

11. The surface coating device as claimed in claim 10, wherein the tablets are arranged along the revolution direction of the mounting jigs with a uniform interval.

12. The surface coating device as claimed in one of the claims 7 to 11, further comprising a sputtering device for sputtering silicon particles into the deposition chamber; and a gas introduction device for introducing reaction gas into the deposition chamber.
